# EUROPEAN PATENT SPECIFICATION

(11) **EP 3 248 854 B1**
(45) Date of publication and mention of the grant of the patent: **20.11.2019**
(21) Application number: 16171184.1
(22) Date of filing: 24.05.2016
(51) Int. Cl.: B61D 25/00, H01L 31/048, H01G 9/20, H02S 20/30, H02S 40/32

(54) **LATERAL PHOTOVOLTAIC WINDOW FOR A PUBLIC TRANSPORTATION VEHICLE, ASSOCIATED PHOTOVOLTAIC POWER GENERATION SYSTEM AND PUBLIC TRANSPORTATION VEHICLE**
SEITLICHES PHOTOVOLTAIKFENSTER FÜR EIN ÖFFENTLICHES VERKEHRSMITTEL, ZUGEHÖRIGES PHOTOVOLTAISCHES ENERGIEERZEUGUNGSSYSTEM UND ÖFFENTLICHES VERKEHRSMITTEL
FENÊTRE PHOTOVOLTAÏQUE LATÉRALE POUR UN VÉHICULE DE TRANSPORT PUBLIC, SYSTÈME DE GÉNÉRATION DE PUISSANCE PHOTOVOLTAÏQUE ASSOCIÉ ET VÉHICULE DE TRANSPORT PUBLIC

(43) Date of publication of application: 29.11.2017
(73) Proprietor: Bombardier Transportation GmbH, 10785 Berlin (DE)
(72) Inventor: Castellazzi, Emanuele, 17020 Ligure Calice (SV) (IT)
(74) Representative: Broydé, Marc

(56) References cited:
- EP-A1- 2 881 301
- EP-A2- 2 466 647
- CN-U- 201 663 568
- DE-A1-102009 029 790
- JP-A- 2007 055 861

## Description

### TECHNICAL FIELD OF THE INVENTION

The present invention relates a lateral window of a passenger rail vehicle, and more generally a lateral window of a public transportation vehicle.

### BACKGROUND ART

CN203573992U discloses a laminated photovoltaic module, comprising in a top-down sequence an upper ultra-clear float glass, an upper transparent polyvinyl butiral (PVB) layer, a sheet of photovoltaic cells, a lower transparent polyvinyl butiral layer and an underlying ordinary PVB transparent glass. The individual photovoltaic cells are connected to one another and to an external circuit by wires. The module can be used in building e.g. as double glass windows, French windows, glass walls, ceiling, sightseeing elevator, balcony, etc. Such modules are custom modules, which have to be specifically designed for each application. In particular, the size and distribution of the individual photovoltaic cells have to be adapted to the size and shape of the available window frame. The photovoltaic cells and wires hinder the view when the observer looking through the photovoltaic module is close to it. Hence, it is not adapted to vehicle windows, in particular to lateral windows of public transportation vehicles. Moreover, the use of amorphous or crystalline silica for conventional photovoltaic cells is problematic because of the low availability of the raw material and of the high cost and energy needed for its manufacture.

DE102009029790 discloses a lateral window for a transportation vehicle, comprising: a first transparent panel, a second transparent panel spaced apart from the first transparent panel, an inner space being defined between the first and second transparent panels, and a photovoltaic generator arranged between the first and second transparent panels. The photovoltaic generator comprises a multi-layered colorant-photovoltaic structure that constitutes an anode and a one-side electrically conductive polymer foil that constitutes a cathode. A generator layer is arranged between the anode and the cathode. The generator layer includes a porous absorber layer in which a liquid ionic material is stored. The ionic material is made of titanium oxide or zinc oxide with artificial colour pigments as ionic partner for a given wavelength range of solar radiation.

### SUMMARY OF THE INVENTION

The invention aims to provide a low cost photovoltaic module for equipping the lateral windows of a public transportation vehicle.

According to the invention, there is provided a lateral window for a public transportation vehicle according to claim 1.

The resulting arrangement offers a uniform transparent surface.

According to an embodiment, the photovoltaic gel contains a silicon gel and a semiconductor.

Preferably, the photovoltaic gel completely fills the inner space.

According to an embodiment, the first and second transparent panels are planar. Curved transparent panels are also possible.

According to an embodiment, the lateral window comprises a filling arrangement for filling the inner space between the first transparent panel and second transparent panel with the photovoltaic gel. This filling arrangement may comprise a filling inlet for introducing the photovoltaic gel into the inner space, a pressure compensation outlet for allowing air to leave the inner space and closure elements for closing the filling inlet and pressure compensation outlet. According to one embodiment, the filling inlet comprises a through hole in the first transparent panel. Similarly, the pressure compensation outlet comprises a through hole in the first transparent panel. This arrangement is particularly simple and makes it possible to fill the inner space after the lateral window has been mounted on the vehicle. Alternatively, the filling inlet and pressure compensation outlet are arranged in one or more frame members of the window frame, with the advantage that the filing inlet and pressure compensation outlet are not visible

According to an embodiment, the lateral window is provided with a pair of electrodes spaced apart from one another for electrically connecting the photovoltaic gel to an outside electrical circuit through the window frame. One of the advantages of the invention is that only one pair of electrodes is necessary, i.e. the whole window operates as a single photovoltaic cell. Preferably, the electrodes are arranged on the window frame. The electrodes are not visible and do not hinder the view.

According to a preferred embodiment at least two openings are provided in the window frame. The two openings form the filling inlet and pressure outlet and are closed by bushings that connect the electrodes to the outside circuit. Alternatively, different openings in the window frame can be used for the electric bushings and the inlet and outlet openings.

According to another aspect of the invention, there is provided a photovoltaic power generation system for a public transportation vehicle, characterized in that it includes a set of one or more lateral windows as described above and an electrical circuit for connecting the electrodes of the one or more lateral windows to one or more electrical components amongst the following:
- a set of one or more batteries;
- one or more DC loads; and/or
- one or more AC loads.

According to an embodiment, the electrical circuit includes a charger controller between the electrodes and the one or more electrical components. Preferably, the lateral windows are connected in parallel.

According to another aspect of the invention, there is provided A public transportation vehicle comprising a side wall provided with lateral window openings, and a photovoltaic power generation system as described hereinbefore, wherein the set of one or more lateral windows of the photovoltaic power generation system are framed into one or more of the window openings.

### BRIEF DESCRIPTION OF THE FIGURES

Other advantages and features of the invention will then become more clearly apparent from the following description of a specific embodiment of the invention given as non-restrictive examples only and represented in the accompanying drawings in which:
- Figure 1 is a diagrammatic illustration of a pair of side walls of a vehicle body of a rail vehicle, provided with lateral windows according to an embodiment of the invention;
- Figure 2 is a partially cut isometric view of an upper inside corner of one of the lateral windows of figure 1, provided with an inlet plug;
- Figure 3 is a section of the upper corner of the lateral window of figure 2;
- Figure 4 is a detailed exploded view of the inlet plug of figure 2;
- Figure 5 is an electric power distribution diagram of a rail vehicle provided with the windows of figure 1;
- Figure 6 is a partially cut isometric view of a lateral window according to a second embodiment of the invention;
- Figure 7 is a cross-section of the upper corner of the lateral window of figure 6;
- Figure 8 is a longitudinal section of the upper corner of the lateral window of figure 6.

Corresponding reference numerals refer to the same or corresponding parts in each of the figures.

### DETAILED DESCRIPTION OF PREFERRED EMBODIMENTS

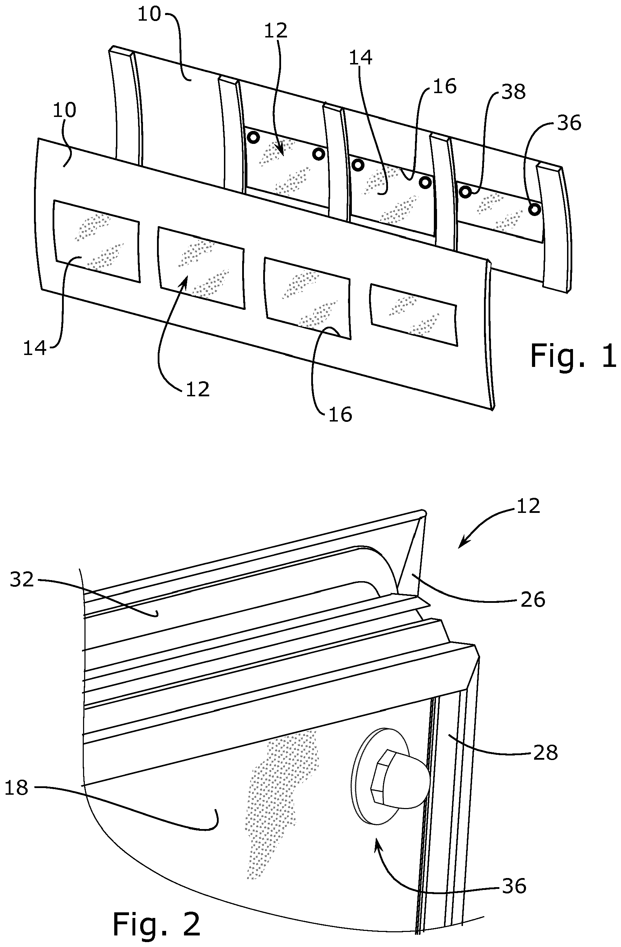

With reference to Figure **1**, the side walls **10** of a public transportation vehicle, and more specifically of a rail vehicle, are provided with lateral windows **12**, each comprising a set of transparent panels **14** glazed to a window frame **16**, which itself is received in a window opening of the side wall **10.**

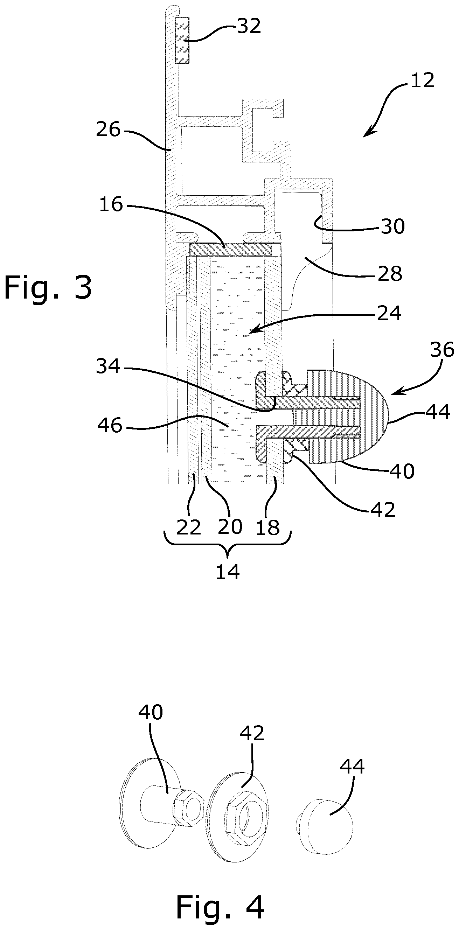

As illustrated in Figures **2** and **3**, the set of transparent panel **14** of each lateral window **12** includes an inner transparent panel **18**, an intermediate transparent panel **20** and an outer transparent panel **22** adhesively bonded to the intermediate transparent panel **18.** A resilient spacer frame (not shown) ensures that the inner transparent panel **18** and the intermediate transparent panel **20** are spaced apart so as to define a closed inner space **24** therebetween. Each transparent panel **18**, **20**, **22** may be made of glass or an appropriate transparent plastic material, e.g. acrylic glass, or may be a multi-layered panel with different materials. Different materials may be used for the inner, outer and/or intermediate transparent panels **18**, **20**, **22.** The outer and intermediate transparent panels **20**, **22** may be replaced with a single panel.

The frame **16** of each lateral window **12** is substantially rectangular and comprises four sides, each formed from a main profile **26** and a clamping profile **28** received in a groove **30** of the main profile **26.** The main profile **26** provides an interface with the side wall **10** of the vehicle. A sealing gasket **32** is provided between the main profile and the side wall of the vehicle. The clamping profile **28** protrudes from the groove **30** and has a region of overlap with the inner transparent panel **18.**

The inner transparent panel **18** has a pair of through holes **34** (only one of which is illustrated in Figure **3**), which constitute an inlet **36** and an outlet **38** between the inner space **24** and the outside. A tubular screw **40** protrudes from each through hole **34.** A nut **42** is screwed on a first thread of the tubular screw **40** to fix the tubular screw **40** to the inner transparent panel **18.** A threaded cap **44** is engaged on a second thread of the tubular screw **40** to close the protruding open end of the tubular screw **40.**

The inlet **36** is used to fill the inner space **24** with a transparent photovoltaic gel **46** while the air in the inner space **24** is expelled through the outlet **38.** Once the inner space **24** has been filled with the photovoltaic gel **46,** the inlet **36** and outlet **38** are closed and sealed with the closure **44.** The inlet **46** and outlet **48** can be of similar construction or can be different from one another (e.g. to include check valves).

The photovoltaic gel is preferably a sol-gel of Si₂Oₓ in a water matrix.

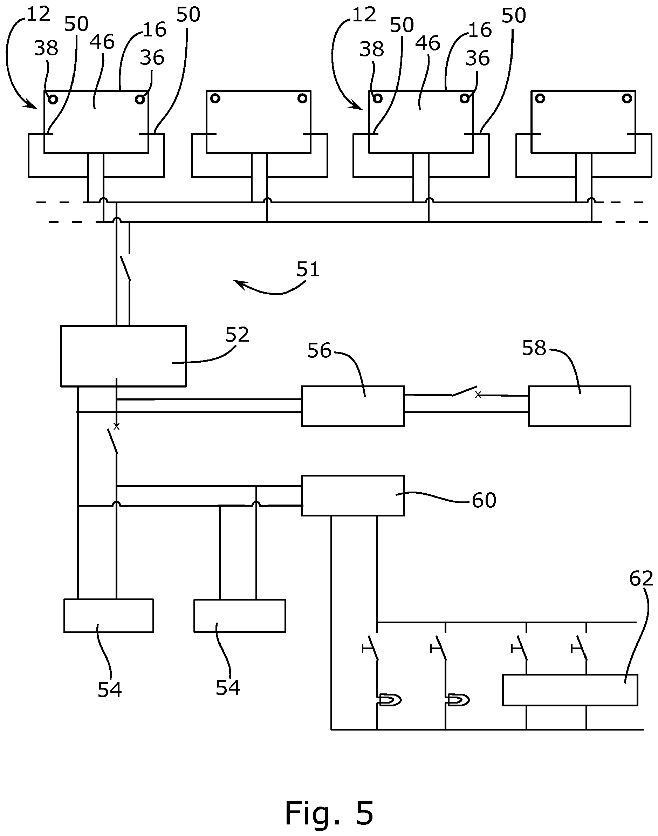

As depicted in Figure **5**, two electrodes **50** are provided on two opposite sides or two opposite corners of the frame **16** and are brought in contact with the transparent photovoltaic gel **46** in the inner space to electrically connect the transparent photovoltaic gel with an electrical circuit **51.** The pairs of electrodes **50** of the lateral windows **12** on one side of the vehicle are connected in parallel with a battery charger controller **52**, which is also connected to a set of batteries **54**, and to a DC/AC inverter **56** to distribute AC power to various AC power consumers **58** in the vehicle. The batteries **54** are connected to a battery discharger controller **60** to distribute DC power to various DC power consumers **62** in the vehicle.

In the operational state, when the vehicle is in or out of service during daylight hours, the lateral windows **12** generate electrical power, which is used either to directly feed the DC/AC inverter **56** or to charge the batteries **54.** Peak performances in standard lighting (**1000** w/m²) are in the range of **90** to **100** W/m². The voltage obtained between the electrodes vary from **2** to **3**,**5** V depending on the thickness of the gel layer. Favourable thicknesses (i.e. distance between inner transparent panel and intermediate transparent panel) range from **4** to **8** mm.

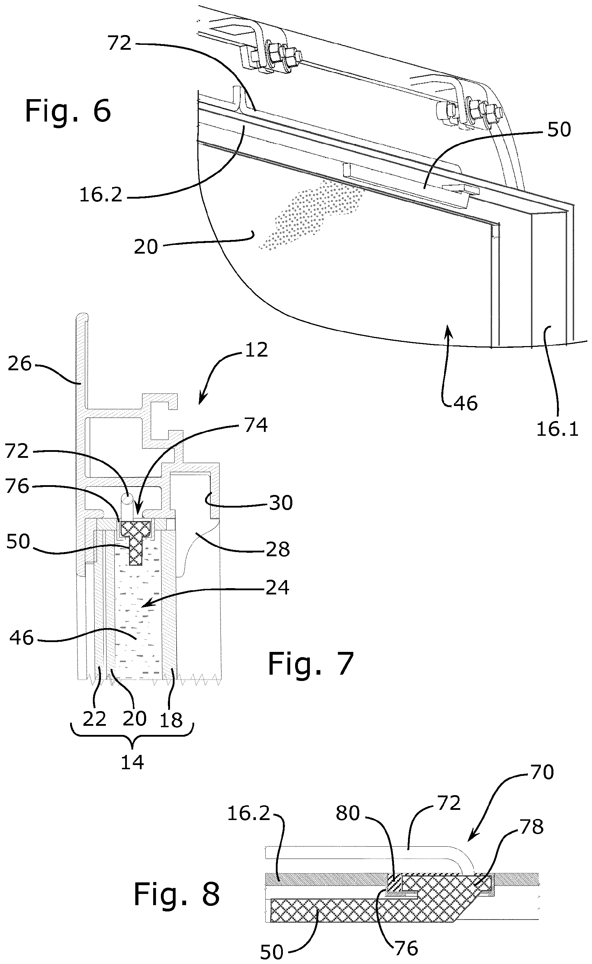

Referring to figures **6** to **8**, a lateral window **12** according to a second embodiment comprises a set of transparent panels **14** glazed to a window frame **16.** The set of transparent panel **14** includes an inner transparent panel **18**, an intermediate transparent **20** panel and an outer transparent panel **22** adhesively bonded to the intermediate transparent panel **18.** A resilient spacer frame (not shown) ensures that the inner transparent panel **18** and the intermediate transparent panel **20** are spaced apart so as to define a closed inner space **24** therebetween. A number of electrodes **50** are distributed on the side members **16.1** upper member **16.2** and lower member of the window frame. Each electrode **50** consists of a metallic rod, which runs parallel to the associated frame member and is immersed in a transparent photovoltaic gel **46** that fills in the inner space **24.** Some of the electrodes **50** may be connected with one another. At least two of the electrodes **50**, preferably associated with the upper member **16.2** of the frame **16**, are connected to an external circuit similar to the circuit **51** of figure **5** through a bushing **70** and a cable **72.** The bushing **70** is illustrated in its final operational state in figure **8.** Figure **8** illustrates an opening **74** in the upper frame member **16.2** for accommodating the bushing **70**, and an open bushing housing **76** received in the opening. The electrodes **50** comprises a T-shaped end portion **78** which forms a key that can slide in the housing from a free position to a locked position illustrated in figure **8****.** Preferably, the whole electrode **50** is shaped such that it can be inserted into the inner space **24** through the bushing housing **76.** Once the T-shaped end portion **78** of the electrode is in the locked position, a sealing cap **80** made of silicone or of a non-cured elastomeric material is injected into the free space between the T-shaped end of the electrode allowed to polymerise to close the bushing **70.**

The opening of the bushing housing is used to fill the inner space **24** of the lateral window **12** with the transparent photovoltaic gel **46**, either before the electrode is put in place, or after the electrode has been inserted in the bushing but before it is locked with the sealing cap **80.** As there are at least two such openings, one can be used as inlet to fill the inner space **24** while the other is used as outlet to expel the air from the inner space **24.**

While the above examples illustrate preferred embodiments of the present invention it is noted that various other arrangements can also be considered, as long as they belong to the scope defined by the appended set of claims. The electrical circuit **51** can include any subset of lateral windows **12** on one or both sides of the vehicle body or one more than one vehicle body. The shape of the window can vary.

## Claims

1. A lateral window (12) for a public transportation vehicle, comprising:
- a first transparent panel (18),
- a second transparent panel (20) spaced apart from the first transparent panel (18); and
- a window frame (16) comprising a main profile (26) for supporting the first transparent panel (18) and the second transparent panel (20), an inner space (24) being defined between the first (18) and second (20) transparent panels and the window frame (16),
**characterised in that** it further comprises a transparent photovoltaic gel (46) filling the inner space (24).

2. The lateral window of claim 1, wherein the photovoltaic gel (46) contains a silicon gel and a semiconductor.

3. The lateral window of any one of the preceding claims, wherein the photovoltaic gel (46) completely fills the inner space (24).

4. The lateral window of any one of the preceding claims, wherein the first (18) and second (20) transparent panels are planar.

5. The lateral window of any one of the preceding claims, further comprising a filling arrangement for filling the inner space (24) between the first transparent panel (18) and second transparent panel (20) with the photovoltaic gel (46).

6. The lateral window of claim 5, wherein the filing arrangement for filling the inner space (24) comprises a filling inlet (36, 74) for introducing the photovoltaic gel (46) into the inner space (24), a pressure compensation outlet (38, 74) for allowing air to leave the inner space (24) and closure elements (44, 80) for closing the filling inlet (36, 74) and pressure compensation outlet (38,74).

7. The lateral window of claim 6, wherein the filling inlet (36) comprises a through hole (34) in the first transparent panel (18).

8. The lateral window of claim 6 or claim 7, wherein the pressure compensation outlet (38) comprises a through hole (34) in the first transparent panel (18).

9. The lateral window of claim 6, wherein the filling inlet (36, 74) and pressure compensation outlet (38, 74) are arranged in one or more frame members (16.1, 16.2) of the window frame (16).

10. The lateral window of any one of the preceding claims, further comprising a pair of electrodes (50) spaced apart from one another for electrically connecting the photovoltaic gel (46) to an outside electrical circuit (51) through the window frame (16).

11. The lateral window of claim 10, wherein the electrodes (50) are arranged on the window frame (16).

12. The lateral window of claim 11 in combination with claim 9, further comprising at least two openings (74) in the window frame (16), wherein the two openings form the filling inlet (36) and pressure outlet (38) and are closed by bushings that connect the electrodes to the outside circuit (51).

13. A photovoltaic power generation system for a public transportation vehicle, **characterized in that** it includes a set of one or more lateral windows (12) according to any one of claims 10 to 12 and an electrical circuit (51) for connecting the electrodes (50) of the one or more lateral windows (12) to one or more electrical components amongst the following:
- a set of one or more batteries (54) ;
- one or more DC loads (58); and/or
- one or more AC loads (62),
wherein the electrical circuit (51) preferably includes a charger controller (52) between the electrodes (50) and the one or more electrical components.

14. The photovoltaic power generation system of claim 13, **characterized in that** the lateral windows (12) are connected in parallel.

15. A public transportation vehicle comprising a side wall (10) provided with lateral window openings, and a photovoltaic power generation system according to claim 13 or claim 14, wherein the set of one or more lateral windows (12) of the photovoltaic power generation system are framed into one or more of the window openings.

## Patentansprüche

1. Seitenfenster (12) für ein öffentliches Beförderungsfahrzeug, umfassend:
- eine erste durchsichtige Fensterscheibe (18),
- eine zweite durchsichtige Fensterscheibe (20), die von der ersten durchsichtigen Fensterscheibe (18) beabstandet ist; und
- einen Fensterrahmen (16), umfassend ein Hauptprofil (26) zum Stützen der ersten transparenten Fensterscheibe (18) und der zweiten transparenten Fensterscheibe (20), wobei ein Innenraum (24) zwischen der ersten (18) und der zweiten (20) durchsichtigen Fensterscheibe und dem Fensterrahmen (16) definiert ist,
**dadurch gekennzeichnet, dass** es weiterhin ein durchsichtiges photovoltaisches Gel (46) umfasst, das den Innenraum (24) ausfüllt.

2. Seitenfenster gemäß Anspruch 1, wobei das photovoltaische Gel (46) ein Siliziumgel auf einem Halbleiter enthält.

3. Seitenfenster gemäß irgendeinem der voranstehenden Ansprüche, wobei das photovoltaische Gel (46) den Innenraum (24) komplett ausfüllt.

4. Seitenfenster gemäß irgendeinem der voranstehenden Ansprüche, wobei die erste (18) und zweite (20) durchsichtige Fensterscheibe eben sind.

5. Seitenfenster gemäß irgendeinem der voranstehenden Ansprüche, weiterhin umfassend eine Füllanordnung zum Füllen des Innenraums (24) zwischen der ersten durchsichtigen Fensterscheibe (18) und der zweiten durchsichtigen Fensterscheibe (20) mit dem photovoltaischen Gel (46).

6. Seitenfenster gemäß Anspruch 5, wobei die Füllanordnung zum Füllen des Innenraums (24) einen Fülleinlass (36, 74) zum Einführen des photovoltaischen Gels (46) in den Innenraum (24), einen Druckausgleichs-Auslass (38, 74), damit Luft den Innenraum (24) verlassen kann, und Verschlusselemente (44, 80) zum Verschließen des Fülleinlasses (36, 74) und einen Druckausgleichs-Auslass (38, 74) umfasst.

7. Seitenfenster gemäß Anspruch 6, wobei der Fülleinlass (36) eine Durchgangsbohrung (34) in der ersten durchsichtigen Fensterscheibe (18) umfasst.

8. Seitenfenster gemäß Anspruch 6 oder Anspruch 7, wobei der Druckausgleichs-Auslass (38) eine Durchgangsbohrung (34) in der ersten durchsichtigen Fensterscheibe (18) umfasst.

9. Seitenfenster gemäß Anspruch 6, wobei der Fülleinlass (36, 74) und der Druckausgleichs-Auslass (38, 74) in einem oder mehreren Rahmenelement(en) (16.1, 16.2) des Fensterrahmens (16) angeordnet sind.

10. Seitenfenster gemäß dem voranstehenden Anspruch, weiterhin umfassend ein Paar Elektroden (50), die zum elektrischen Anschließen des photovoltaischen Gels (46) durch den Fensterrahmen (16) an einen äußeren elektrischen Schaltkreis (51) voneinander beabstandet sind.

11. Seitenfenster gemäß Anspruch 10, wobei die Elektroden (50) auf dem Fensterrahmen (16) angeordnet sind.

12. Seitenfenster gemäß Anspruch 11 in Verbindung mit Anspruch 9, weiterhin umfassend wenigstens zwei Öffnungen (74) in dem Fensterrahmen (16), wobei die zwei Öffnungen den Fülleinlass (36) und den Druckauslass (38) bilden und durch Muffen geschlossen sind, die die Elektroden an den äußeren Schaltkreis (51) anschließen.

13. Photovoltaisches Stromerzeugungssystem für ein öffentliches Beförderungsfahrzeug, **dadurch gekennzeichnet, dass** es einen Satz aus einem oder mehreren Seitenfenster(n) (12) gemäß irgendeinem der Ansprüche 10 bis 12 und einen elektrischen Schaltkreis (51) zum Anschließen der Elektroden (50) des einen oder der mehreren Seitenfenster(s) (12) an ein oder mehrere aus den folgenden elektrischen Bauteil(en) enthält:
- einen Satz aus einer oder mehreren Batterie(n) (54);
- eine oder mehrere Gleichstrom-Last(en) (58); und / oder
- eine oder mehrere Wechselstrom-Last(en) (62),
wobei der elektrische Schaltkreis (51) bevorzugt einen Ladekontroller (52) zwischen den Elektroden (50) und dem einem der den mehreren elektrischen Bauteil(en) enthält.

14. Photovoltaisches Stromerzeugungssystem gemäß Anspruch 13, **dadurch gekennzeichnet, dass** die Seitenfenster (12) parallel angeschlossen sind.

15. Öffentliches Beförderungsfahrzeug, umfassend eine Seitenwand (10), die mit Seitenfenster-Öffnungen bereitgestellt sind, und ein photovoltaisches Stromerzeugungssystem gemäß Anspruch 13 oder Anspruch 14, wobei der Satz aus einem oder mehreren Seitenfenster(n) (12) des photovoltaischen Stromerzeugungssystems in einer oder mehreren Fensteröffnung(en) eingerahmt ist.

## Revendications

1. Fenêtre latérale (12) pour un véhicule de transport public, comprenant :
- un premier panneau transparent (18),
- un second panneau transparent (20) espacé du premier panneau transparent (18) ; et
- un cadre de fenêtre (16) comprenant un profilé principal (26) pour supporter le premier panneau transparent (18) et le second panneau transparent (20), un espace intérieur (24) étant défini entre les premier (18) et second (20) panneaux transparents et le cadre de fenêtre (16),
**caractérisée en ce qu'**elle comprend en outre un gel photovoltaïque transparent (46) remplissant l'espace intérieur (24).

2. Fenêtre latérale selon la revendication 1, dans laquelle le gel photovoltaïque (46) contient un gel de silicium et un semi-conducteur.

3. Fenêtre latérale selon l'une quelconque des revendications précédentes, dans laquelle le gel photovoltaïque (46) remplit complètement l'espace intérieur (24).

4. Fenêtre latérale selon l'une quelconque des revendications précédentes, dans laquelle les premier (18) et second (20) panneaux transparents sont plans.

5. Fenêtre latérale selon l'une quelconque des revendications précédentes, comprenant en outre un dispositif de remplissage pour remplir l'espace intérieur (24) entre le premier panneau transparent (18) et le second panneau transparent (20) avec le gel photovoltaïque (46).

6. Fenêtre latérale selon la revendication 5, dans laquelle le dispositif de remplissage pour remplir l'espace intérieur (24) comprend une entrée de remplissage (36, 74) pour introduire le gel photovoltaïque (46) dans l'espace intérieur (24), une sortie de compensation de pression (38, 74) pour permettre à l'air de quitter l'espace intérieur (24) et des éléments de fermeture (44, 80) pour fermer l'entrée de remplissage (36, 74) et la sortie de compensation de pression (38, 74).

7. Fenêtre latérale selon la revendication 6, dans laquelle l'entrée de remplissage (36) présente un trou traversant (34) dans le premier panneau transparent (18).

8. Fenêtre latérale selon la revendication 6 ou la revendication 7, dans laquelle la sortie de compensation de pression (38) présente un trou traversant (34) dans le premier panneau transparent (18).

9. Fenêtre latérale selon la revendication 6, dans laquelle l'entrée de remplissage (36, 74) et la sortie de compensation de pression (38, 74) sont disposées dans un ou plusieurs élément(s) de cadre (16.1, 16.2) du cadre de fenêtre (16).

10. Fenêtre latérale selon l'une quelconque des revendications précédentes, comprenant en outre une paire d'électrodes (50) espacées l'une de l'autre pour connecter électriquement le gel photovoltaïque (46) à un circuit électrique extérieur (51) à travers le cadre de fenêtre (16).

11. Fenêtre latérale selon la revendication 10, dans laquelle les électrodes (50) sont disposées sur le cadre de fenêtre (16).

12. Fenêtre latérale selon la revendication 11 en combinaison avec la revendication 9, comprenant en outre au moins deux ouvertures (74) dans le cadre de fenêtre (16), dans laquelle les deux ouvertures forment l'entrée de remplissage (36) et la sortie de pression (38) et sont fermées par des embouts qui relient les électrodes au circuit extérieur (51).

13. Système de production d'énergie photovoltaïque pour un véhicule de transport public, **caractérisé en ce qu'**il comprend un ensemble d'une ou plusieurs fenêtre(s) latérale(s) (12) selon l'une quelconque des revendications 10 à 12 et circuit électrique (51) pour connecter les électrodes (50) d'une ou plusieurs fenêtre(s) latérale(s) (12) à un ou plusieurs composant(s) électrique(s) parmi les suivants :
- un jeu d'une ou plusieurs batteries(s) (54) ;
- une ou plusieurs charge(s) CC (58) ; et/ou
- une ou plusieurs charge(s) CA (62),
dans lequel le circuit électrique (51) comprend de préférence un contrôleur de chargeur (52) entre les électrodes (50) et le ou les composant (s) électrique (s).

14. Système de production d'énergie photovoltaïque selon la revendication 13, **caractérisé en ce que** les fenêtres latérales (12) sont connectées en parallèle.

15. Véhicule de transport public comprenant une paroi latérale (10) pourvue d'ouvertures latérales de fenêtre, et système de production d'énergie photovoltaïque selon la revendication 13 ou la revendication 14, dans lequel l'ensemble d'une ou plusieurs fenêtre(s) latérale(s) (12) du système de production d'énergie photovoltaïque sont encadrées dans une ou plusieurs des ouvertures de fenêtre.
